# EUROPEAN PATENT SPECIFICATION

(11) **EP 4 100 707 B1**
(45) Date of publication and mention of the grant of the patent: **14.10.2026**
(21) Application number: 21792638.5
(22) Date of filing: 29.01.2021
(51) Int. Cl.: G01J 1/04, G01J 1/02, H10N 60/01, H10N 60/84, H01B 12/06, G01J 5/20, G01J 1/44, G01J 1/42

(54) **SNSPD WITH INTEGRATED ALUMINUM NITRIDE SEED OR WAVEGUIDE LAYER**
SNSPD MIT INTEGRIERTER ALUMINIUMNITRIDKEIM- ODER WELLENLEITERSCHICHT
SNSPD À COUCHE DE GUIDE D'ONDES OU DE GERMES EN NITRURE D'ALUMINIUM INTÉGRÉE

(30) Priority: 03.02.2020 US 202062969611 P
(43) Date of publication of application: 14.12.2022
(73) Proprietor: Applied Materials, Inc., Santa Clara, California 95054 (US)
(72) Inventor: YANG, Zihao, Santa Clara, California 95051 (US); ZHU, Mingwei, San Jose, California 95132 (US); PATIBANDLA, Nag B., Pleasanton, California 94566 (US); YAHAV, Nir, Sunnyvale, California 94087 (US); VISSER, Robert Jan, Menlo Park, California 94025 (US); DE LA ZERDA, Adi, Los Altos, California 94022 (US)
(74) Representative: Zimmermann & Partner Patentanwälte mbB
(86) International application number: PCT/US2021/015798
(87) International publication number: WO 2021/216162

(56) References cited:
- CN-A- 106 558 632
- CN-A- 108 666 409
- CN-A- 110 057 446
- CN-B- 106 549 097
- JP-A- 2018 074 026
- US-A1- 2008 128 745
- US-A1- 2018 364 097
- US-B1- 6 347 106
- FRANCESCO MARSILI ET AL: "High quality superconducting NbN thin films on GaAs", SUPERCONDUCTOR SCIENCE AND TECHNOLOGY, IOP PUBLISHING, TECHNO HOUSE, BRISTOL, GB, vol. 22, no. 9, 1 September 2009 (2009-09-01), pages 95013, XP020164281, ISSN: 0953-2048, DOI: 10.1088/0953-2048/22/9/095013
- ZHANG J J ET AL: "Paper;Improvement of the superconducting properties of NbN thin film on single-crystal silicon substrate by using a TiN buffer layer;Improvement of the superconducting properties of NbN thin film on single-crystal silicon substrate by using a TiN buffer layer", SUPERCONDUCTOR SCIENCE AND TECHNOLOGY, IOP PUBLISHING, TECHNO HOUSE, BRISTOL, GB, vol. 26, no. 4, 7 March 2013 (2013-03-07), pages 45010, XP020239624, ISSN: 0953-2048, DOI: 10.1088/0953-2048/26/4/045010
- SCHMIDT E ET AL: "AlN-buffered superconducting NbN nanowire single-photon detector on GaAs", ARXIV.ORG, CORNELL UNIVERSITY LIBRARY, 201 OLIN LIBRARY CORNELL UNIVERSITY ITHACA, NY 14853, 30 September 2016 (2016-09-30), XP081361490, DOI: 10.1109/TASC.2016.2637358

## Description

### BACKGROUND

### Technical Field:

The disclosure concerns a superconducting nanowire single photon detector (SNSPD) that includes a seed layer below the metal nitride that provides the superconductive material.

### Background Discussion

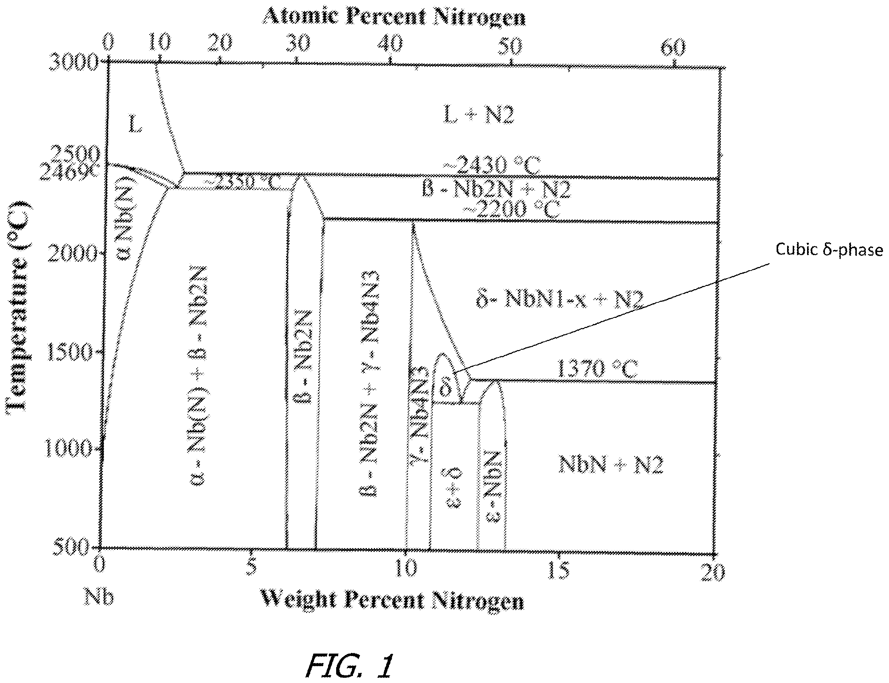

In the context of superconductivity, the critical temperature (Tc) refers to the temperature below which a material becomes superconductive. Niobium nitride (NbN) is a material that can be used for superconducting applications, e.g., superconducting nanowire single photon detectors (SNSPD) for use in quantum information processing, defect analysis in CMOS, LIDAR, etc. The critical temperature of niobium nitride depends on the crystalline structure and atomic ratio of the material. For example, referring to FIG. 1, cubic δ-phase NbN has some advantages due to its relatively "high" critical temperature, e.g., 9.7-16.5 °K.

Niobium nitride can be deposited on a workpiece by physical vapor deposition (PVD). For example, a sputtering operation can be performed using a niobium target in the presence of nitrogen gas. The sputtering can be performed by inducing a plasma in the reactor chamber that contains the target and the workpiece.

Marsili et al., "High quality superconducting NbN thin films on GaAs", Superconductor science and technology, IOP Publishing, Techno House, Bristol, GB, Vol. 22, No. 9, 1 September 2009, page 95013, XP020164281, describes nanowire superconducting single-photon detectors. An NbN film is grown on an AlAs/GaAs distributed Bragg reflector fabricated on a GaAs substrate. A buffer layer of MgO can be provided on a GaAs substrate in order to enhance the microstructure of NbN films on GaAs. CN 106 549 097 B describes a superconducting nanowire single-photon detector including a substrate, a high reflective film on the surface of the substrate and a superconducting nanowire on the surface of the high reflective film. The high reflective film includes a SiO2 layer and a Si thin film layer that are alternately stacked. Zhang et al., "Improvement of the superconducting properties of NbN thin film on single-crystal silicon substrate by using a UN buffer layer", Superconductor science and technology, TOP Publishing, Techno House, Bristol, GB, Vol. 26, No. 4, 7 March 2013, page 45010, XP020239624, describes NbN films on silicon substrates in the context of superconducting nanowire single-photon detectors and describes a TiN buffer layer. Schmidt et al., "AIN buffered superconducting NbN nanowire single-photon detector on GaAs", Arxiv.org, Cornell University Library, 30 September 2016, XP081361490, describes AIN as a buffer layer for NbN superconducting nanowire single-photon detectors.

### SUMMARY

A superconducting nanowire single photon detector (SNSPD) device according to the invention is disclosed in claim 1.

According to an embodiment, the superconducting nanowire single photon detector (SNSPD) includes a distributed Bragg reflector comprising a plurality of bi-layers, each bi-layer including lower layer of aluminum nitride and an upper layer of a different material having a higher index of refraction than the aluminum nitride, the seed layer is aluminum nitride, and the superconductive wire is niobium nitride, titanium nitride, or niobium titanium nitride.

Implementations may provide, but are not limited to, one or more of the following advantages. A device based on absorption of photons by a superconductive material, e.g., an SNSPD, can have high photon absorption efficiency while also achieving high material quality for the superconductive layer, .e.g. the niobium nitride, and thus a higher critical temperature. This permits fabrication of devices, e.g., SNSPD, with superconductive wires with a higher critical temperature. The larger difference between the operating temperature (2-3°K) and the critical temperature provides superior detection efficiency, lower dark count, and possibly faster temporal response.

It should be noted that "superconductive" indicates that the material becomes superconducting at the operating temperature of the device, e.g., 2-3°K. The material is not actually superconducting during fabrication of the device at or above room temperature or when the device is not being cooled for operation.

The details of one or more implementations are set forth in the accompanying drawings and the description below. Other potential aspects, features, and advantages will become apparent from the description, the drawings, and the claims.

### BRIEF DESCRIPTION OF THE DRAWINGS

FIG. 1 diagram illustrating phase of niobium nitride as a function of processing temperature and atomic percentage nitrogen.
FIG. 2A is a schematic top view of a SNSPD that includes a distributed Bragg reflector.
FIG. 2B is a schematic cross-sectional side view of the device of FIG. 2A.
FIG. 3 is a schematic illustration of the operation of a SNSPD.
FIG.4 is a schematic cross-sectional side view of a SNSPD that includes a distributed Bragg reflector and an aluminum nitride seed layer.
FIG. 5 is a graph of reflectance as a function of wavelength for two SNSPD designs.
FIG. 6 is a graph of critical temperature as a function of thickness of a NbN layer, with and without an aluminum nitride seed layer.
FIG. 7 is a flow chart of a method of fabricating a SNSPD.
FIG. 8A is a schematic top view of a SNSPD that includes a waveguide.
FIG. 8B is a schematic cross-sectional side view of the device of FIG. 8A.
FIG. 9 is a schematic cross-sectional side view of a SNSPD that includes a waveguide and an aluminum nitride seed layer .
FIG. 10 is a schematic cross-sectional side view of a SNSPD that includes a waveguide formed of aluminum nitride.

Like reference numbers and designations in the various drawings indicate like elements.

### DETAILED DESCRIPTION

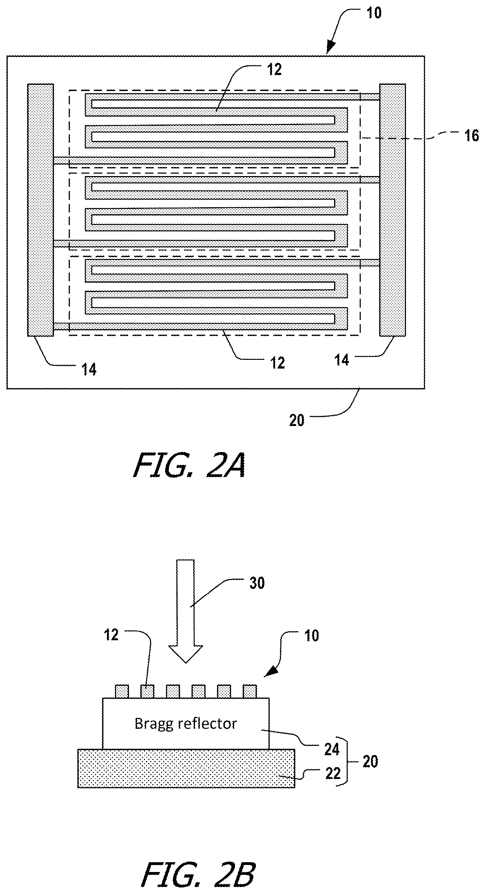

FIGS. 2A and 2B illustrate top and side views, respectively, of a conventional superconducting nanowire single photon detector (SNSPD) device 10. The SNSPD device 10 can include at least one superconductive wire 12 disposed on a support structure 20. The superconductive wire 12 can be connected between conductive electrodes 14. The superconductive wire 12 can be arranged in a meandering pattern, e.g., a back-and-forth parallel lines, on the supporting structure 20. In some implementations, multiple wires 12 are connected in parallel between the electrodes 14, with each wire 12 covering a separate area 16, but there could be just a single wire 12 covering the entire detection area of the device 10. In addition, many other patterns are possible, e.g., zigzag or double spiral. The superconductive wire can be considered a nanowire, e.g., can have a width of about 30 nm and a thickness of about 10 nm.

The support structure 20 can include a substrate 22, e.g., a silicon substrate, and a mirror structure 24 disposed on the substrate 22. As an example, the mirror structure 24 can be a distributed Bragg reflector (DBR) that includes multiple pairs of layers formed of high refractive index and low refractive index materials.

A conventional SNSPD is operated with a photon (illustrated by light beam 30) approaching from the top of the device 10, e.g., with normal incidence relative to the substrate 20. A simple device would be have the NbN nanowires disposed directly on the silicon substrate (without the mirror structure). Because the NbN nanowires are typically very thin in a SNSPD device, most of the light is not absorbed by the NbN nanowire. To boost the light absorption efficiency, the mirror structure 24, e.g., the distributed Bragg reflector, is incorporated in the device 10 between the substrate 20 and the wires 12. In this case, incident photons that are not initially absorbed can be absorbed on reflection, so the photons have a higher probability to be captured by the NbN nanowires.

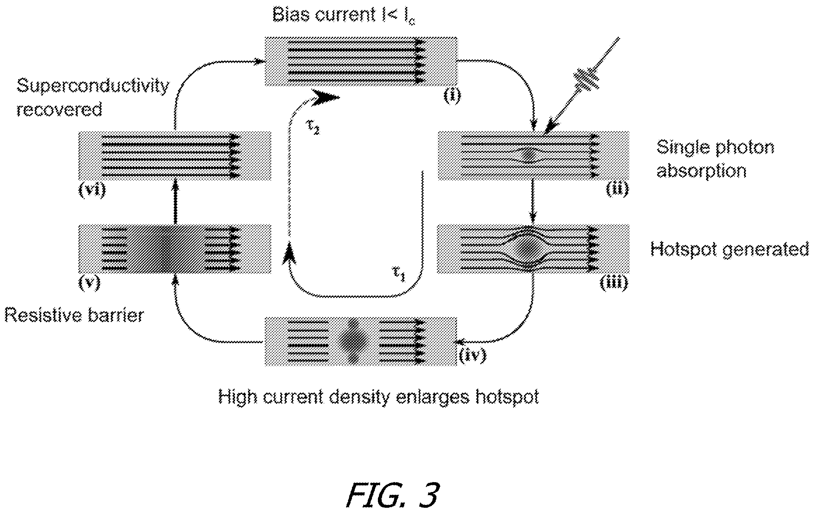

Referring to FIG. 3, the working principle of the SNSPD device is that the to-be-detected photon comes from top and shines on the SNPSD. Absorption of the photon creates a hot spot on the NbN nanowire, which raises the temperature of the NbN above critical temperature so that a portion of the wire is no longer in the superconductive state. A region around the hot spot can experience current crowding, resulting in a higher current density than the critical current density, which can disrupt the superconductive state for the entire wire. The change in the NbN wire from the superconducting state to the normal resistive state can be electrically detected by flowing a current through the device and monitoring voltage differences between the electrodes.

NbN based SNSPDs are mainly used for time-correlated single-photon counting (TCPSC) related applications in the visible and infrared wavelength. For example, SNSPDs are used in quantum metrology (quantum key generation, quantum emitter) and optical quantum computing (detection module) due to their high efficiency, low dark count, low timing jitter, and fast recover time. They can be also used as detectors in classical space-to-ground communications and time-of-flight LIDAR system.

In the visible wavelength range, Si avalanche photodiodes (APDs) are typically used. The system detection efficiency is not ideal, e.g., is about 70%, and these devices are hard to integrate with chip-scale devices.

In the infrared wavelength range, InGaAs APDs are a candidate for many applications. But these devices usually suffer from high dark count rates and even lower system detection efficiency (< 30%) with limited detection speed. Compared to APDs, SNSPDs, have superior performance which includes low timing jitter (< 20ps), fast recover time, high detection efficiency (> 85%), and low dark count rates (~ a few Hz).

As noted above, niobium nitride, particularly δ-phase NbN, has some advantages as a superconductive material. However, δ-phase NbN can be difficult to deposit at a satisfactory quality. A seed layer, e.g., an aluminum nitride (AlN) layer, below the (super)conductive layer can help improve the critical temperature of the NbN layer. The aluminum nitride (AlN) seed layer can also improve the critical temperature of TiN and NbTiN layers, and may also be helpful for other metal nitride layers. In particular, the aluminum nitride layer can be integrated into a SNSPD device, and in particular be integrated into the mirror structure or waveguide of a SNSPD device. This permits a higher crystal quality metal nitride detector (thus higher critical temperature, and thus better device performance) to be achieved while also enabling high light absorption efficiency.

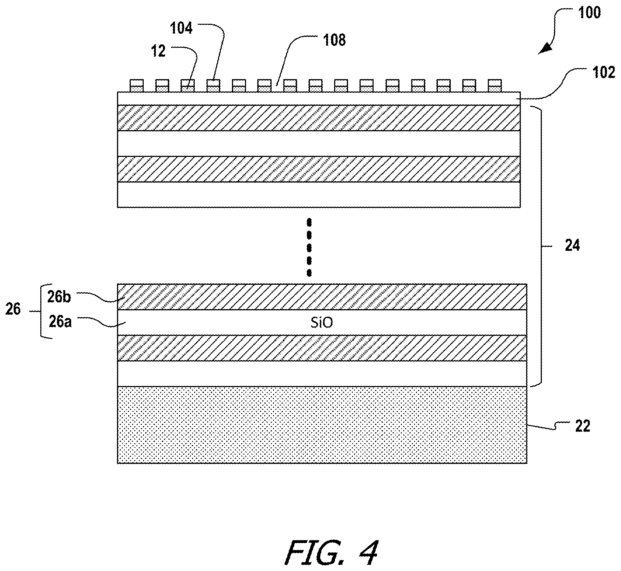

FIG. 4 illustrates a cross-sectional side view of a superconducting nanowire single photon detector (SNSPD) device 100. The SNSPD device 100 can be similar to the device described above with respect to FIGS. 2A and 2B, except as described below.

The SNSPD includes a substrate 22, which can be a dielectric material, e.g., sapphire, SiO₂, fused silica, or quartz, or a semiconductor material, e.g., silicon, gallium nitride (GaN) or gallium arsenide (GaAs).

A distributed Bragg reflector (DBR) 24 is fabricated on top of the substrate 22. The DBR 24 includes multiple bi-layers 26, e.g., two to eight bi-layers, e.g., seven bi-layers. Each bi-layer 26 includes a lower layer 26a of a first material having a first index of refraction (the "low index of refraction") and an upper layer 26b of a second material having a second index of refraction (the "high index of refraction") that is greater than the first index refraction. The thicknesses and materials (and thus indices of refraction) in the bilayers 26 are selected to increase reflection in a selected wavelength or wavelength band. For example, the DBR may be optimized for reflection of light of about 1500-1600 nm, as 1550 nm is a widely used wavelength in optical communication systems.

The first material and the second material can both be selected from Table 1, subject to the restriction that the second material has a higher index of refraction than the first material.

**Table 1**

| Material | Refractive index (for 1550nm light) |
|---|---|
| a-Si | ~3.4-3.5 |
| TiO₂ | ~2.2-2.3 |
| Nb₂O₅ | ~2.1-2.2 |
| Ta₂O₅ | ~2.05-2.15 |
| AlN | ~1.95-2.05 |
| Si₃N₄ | ~1.9-2.0 |
| SiO₂ | ~1.4-1.5 |

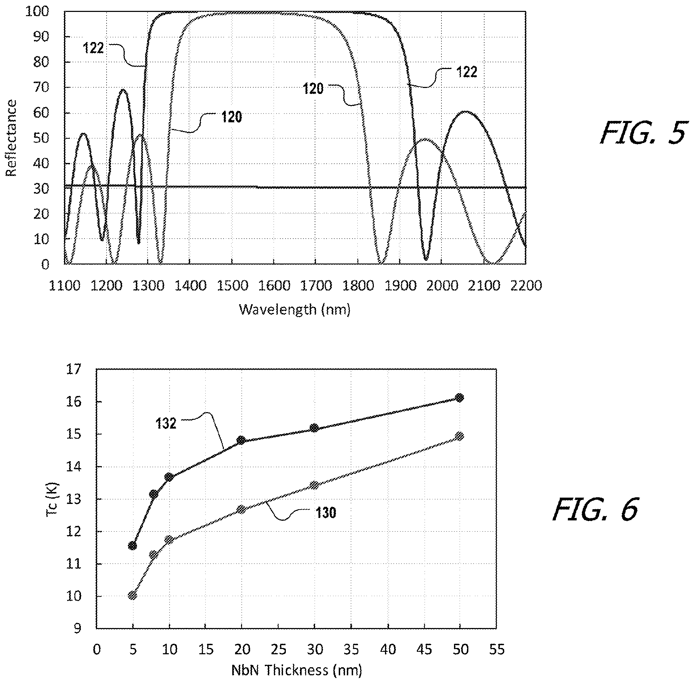

Covering the upper layer 26b of the topmost bilayer 26 of the distributed Bragg reflector, e.g., in direct contact with the upper layer 26b, is a metal nitride layer seed layer 102. The seed layer 102 and the superconductive wires 12 are nitrides of different metals. In particular, the seed layer 102 can be aluminum nitride (AlN), as this improves the critical temperature of NbN. However, hafnium nitride (HfN), gallium nitride (GaN) might also be suitable. The metal nitride seed layer 102 can have a thickness of about 4 to 50 nm, e.g., about 5 nm or about 10 nm or about 20 nm thickness. The seed layer 102 can have a (002) c-axis crystal orientation. The seed layer 102 is not superconducting at the operating temperature of the device 100. The seed layer 102 can be deposited by a standard chemical vapor deposition or physical vapor deposition process.(1) = In some examples not encompassed by the wording of the claims, but useful for understanding the invention, the high index of refraction material of the upper layer 26b is Ta₂O₅, e.g., of about 182 nm thickness, and the low index of refraction material of the lower layer 26a is SiO₂, e.g., of about 263 nm thickness. The reflectance, as simulated by optical modelling software, of a stack of seven such bilayers with an AlN seed layer of 20 nm thickness is shown by curve 120 in FIG. 5.

In an embodiment of particular interest, the seed layer 102 is aluminum nitride, and the low-index material, i.e., the material of each lower layer 26a, is also aluminum nitride. This permits the seed layer 102 to be fabricated using the same processing conditions as the lower-layers in the distributed Bragg reflector 24, and thus simplifies processing requirements. In some implementations, the high index of refraction material is amorphous silicon (a-Si), e.g., of about 111 nm thickness, and the low index of refraction material is AlN, e.g., of about 197 nm thickness. The reflectance, as simulated by optical modelling software, of a stack of seven such bilayers with an AlN seed layer of 20 nm thickness is shown by curve 122 in FIG. 5.

The superconductive wires 12 are formed on, e.g., in direct contact with, the seed layer 102. The wires are formed of niobium nitride (NbN), titanium nitride (TiN), or niobium titanium nitride (Nb_{X}Ti_{1-X}N). The wires 12 can have a width of about 25 to 250 nm, e.g., about 60 nm, and a thickness of 4 to 50 nm, e.g., about 5 nm or about 10 nm or about 20 nm.

The seed layer 102 helps improve the critical temperature of the aluminum nitride, especially when the aluminum nitride layer is thin. For example, FIG. 6 illustrates the measured critical temperature Tc (in Kelvin) as a function of thickness of a NbN layer. Curve 130 illustrates the critical temperature without an aluminum nitride seed layer, and curve 132 illustrates the critical temperature with an aluminum nitride seed layer (for a simplified stack of a silicon wafer, AlN seed layer, and NbN layer). Alternatively or in addition, the seed layer 102 can improve adhesion between the aluminum nitride layer 102 and the upper layer 26b of the distributed Bragg reflector 24.

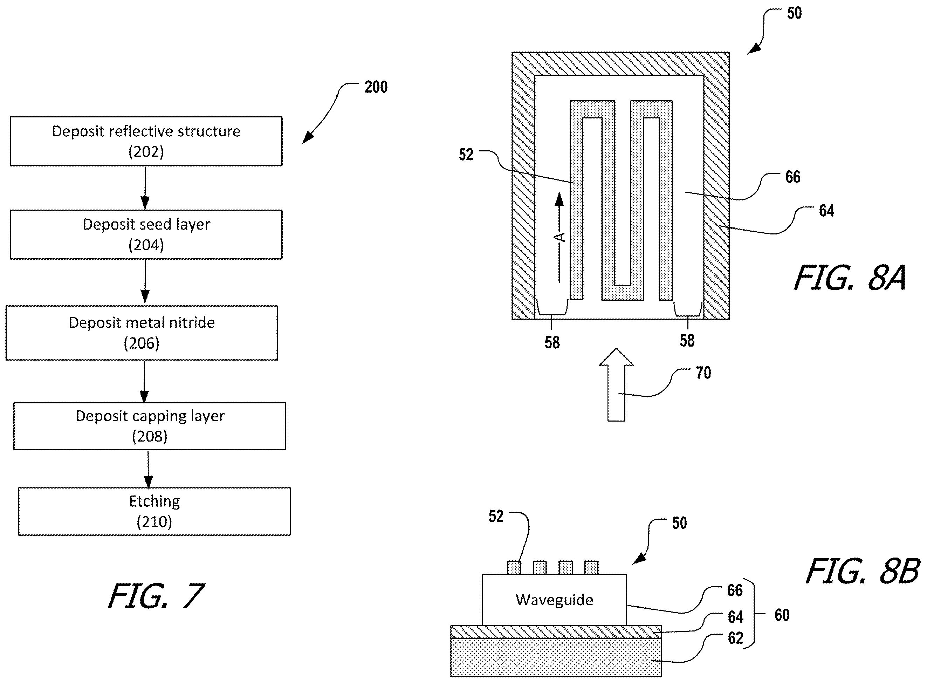

FIG. 7 is a flowchart of a method 200 of fabrication of the device 100 of FIG. 4

Initially, the distributed Bragg reflector (DBR) 24 is deposited on a substrate 100 (step 202). The substrate can be, for example, a silicon wafer. Although illustrated as a single block, the substrate 22 could include multiple underlying layers. The DBR 24 can be deposited by alternating deposition of the high and low index materials using a standard chemical vapor deposition or physical vapor deposition process.

Next, the seed layer 102 is deposited on the DBR 24 (step 204). As mentioned above, the seed layer 102 can be aluminum nitride. The seed layer can be deposited using a standard chemical vapor deposition or physical vapor deposition process. Exemplary processing parameters are a power applied to the sputtering target of 1-5 kW, a total pressure (nitrogen and inert gas) of 2 to 20 mTorr with nitrogen gas and inert gas supplied at a ratio between 3:100 and 1:6, a wafer temperature of 200-500°C, and no bias voltage applied to the wafer. In some implementations, the seed layer 102 is deposited in the same processing chamber that is used to deposit the DBR 24, e.g., by switching in a new target. This permits higher throughput manufacturing. Alternatively, the substrate can be transported to a different deposition chamber without breaking vacuum. Either case permits the seed layer to be deposited without exposure of the DBR to atmosphere and with lower risk of contamination.

Next, the metal nitride layer 12, e.g., the niobium nitride (NbN), titanium nitride (TiN), or niobium titanium nitride (Nb_{X}Ti_{1-X}N), is deposited on the seed layer (step 206). The metal nitride layer 12 can be deposited using a standard chemical vapor deposition or physical vapor deposition process. Exemplary processing parameters are a base pressure of 1e-8 Torr, a power applied to the target of 1-3kW, a total pressure during processing of 5-7mTorr, a wafer temperature of 400C, no bias voltage applied to the wafer, and a percentage of the gas as N₂ sufficient to achieve cubic δ-phase NbN. In some implementations, the metal nitride layer 12 is deposited in the same processing chamber that is used to deposit the seed layer 102, e.g., by switching in a new target. This permits higher throughput manufacturing. Alternatively, the substrate can be transported to a different deposition chamber without breaking vacuum. This permits the metal nitride layer to be deposited without exposure of the seed layer to atmosphere and with lower risk of contamination.

After the metal nitride layer 12 is deposited, a capping layer 104 can be deposited on the metal nitride layer 12 (step 208). The capping layer 104 serves as a protective layer, e.g., to prevent oxidation of the metal nitride layer 12 or other types of contamination or damage. The capping layer 104 can be dielectric or conductive but is not superconductive at the operating temperature of the device 200. The capping layer 104 can be amorphous silicon (a-Si). In some implementations, the capping layer 104 is a nitride of a different material from the metal of the metal nitride used for the superconductive layer 12. Examples of materials for the capping layer 104 include AlN, Al₂O₃, SiO₂, and SiN. The capping layer 104 can be deposited by a standard chemical vapor deposition or physical vapor deposition process.

Etching can be used to form trenches 108 through at least the metal nitride layer 12 to form the conductive wires 12 or other structures needed for the device 100 (step 210). Although FIG. 4 illustrates the trench as extending through the metal nitride layer 12 and capping layer 104, other configurations are possible. As an example, the trenches can extend partially into or entirely through the seed layer 102. However, the trenches should not extend into the mirror structure 24.(2) = In an example not encompassed by the wording of the claims, but useful for understanding the invention, another form of superconducting nanowire single photon detector (SNSPD) device includes a waveguide to input photons into the detector along an axis generally parallel to the surface of the substrate. FIGS. 8A and 8B illustrate a conventional SNSPD 50 having such a waveguide. The SNSPD 50 can include ate least one superconductive wire 52 disposed on a support structure 60. The support structure can include a substrate 62, e.g., a silicon substrate, a dielectric layer 64 on the substrate 62, and a waveguide 66 disposed on the dielectric layer 64. The dielectric layer 64 is a first material having a first refractive index, and the waveguide 66 is a second material having a second refractive index that is higher than the first refractive index.

The superconductive wire 52 can be considered a nanowire, e.g., can have a width of about 30 nm and a thickness of about 10 nm. The superconductive wire(s) 52 can be arranged to form a plurality of parallel lines, with adjacent lines connected at alternating ends. Although FIG. 8A illustrates four parallel lines, the device could have just two parallel lines, e.g., a U-shaped wire, or a greater number of lines.

Photons, shown by light beam 70, are injected into the device from the side, e.g., generally parallel to the top surface of the substrate 62, through the waveguide layer 66. In particular, the photons can enter along an axis (shown by arrow A) generally parallel to the parallel lines of the wire 52. In addition, along the axis transverse to the direction of light propagation, the wire 52 can be located near the center of the waveguide. For example, on each side of device, there can be a gap 58 between the outer edge of the wire 52 and the outer edge of the waveguide 66. This gap 58 can have a width of about 25-30% of the total width of the waveguide.

In general, because the dielectric layer 64 below the waveguide 66 and the empty space or air above the waveguide 66 both have a lower refractive index than the waveguide 66, the photons in the waveguide 66 are trapped by total internal reflection. However, due to the optical coupling between the waveguide 66 and the nanowire 52, the photons can escape into the nanowires 52 and thus be absorbed by the nanowire 62. The light coupling efficiency can be very high in this type of device.

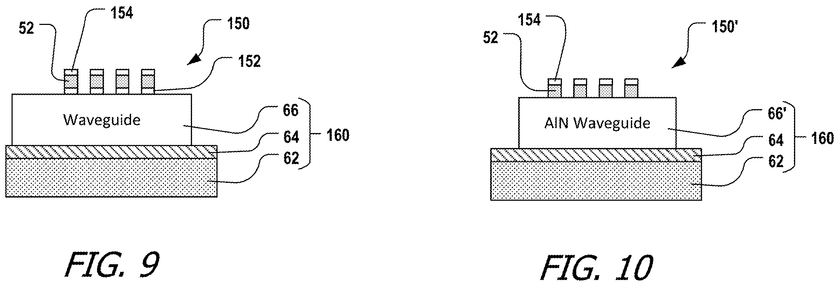

FIG. 9 illustrates a cross-sectional side view of a waveguide-configuration of a superconducting nanowire single photon detector (SNSPD) device 150. The SNSPD device 150 can be similar to the devices described above with respect to FIGS. 4 and 8, except as described below.

The SNSPD device 150 includes a substrate 62, such as a silicon substrate.

Covering the top surface of the substrate 62 is the dielectric layer 64. The dielectric layer 64 can be silicon oxide (SiO₂), although other materials having a refractive index less than that of the waveguide 66 are possible. The dielectric layer 64 can have a thickness of at least 100 nm, e.g., 200 to 2 um.

The waveguide 66 is disposed on the dielectric layer 64. The waveguide 64 can be silicon nitride (Si₃N₄), although other materials having a refractive index greater than that of the dielectric layer 64 are possible. The particular thickness and width of the waveguide can be selected based on the wavelength of light to be captured and detected. The waveguide 66 can have a thickness of 400 to 500 nm, e.g., 450 nm, for 1550 nm light. The width of the waveguide 66, i.e., perpendicular to the direction of propagation of the light entering the waveguide 66, can be 1.1 to 1.3 um, e.g., 1.2 um for 1550 nm light.

On the top surface of the waveguide 66, e.g., in direct contact with the waveguide 66, is a metal nitride seed layer 152. The seed layer 152 and the superconductive wires 52 are nitrides of different metals. In particular, the metal nitride of the seed layer 152 can be aluminum nitride (AlN), as this improves the critical temperature of NbN. However, gallium nitride (GaN) might also be suitable. The seed layer 152 can have a thickness of about bout 4 to 50 nm, e.g., about 5 nm or about 10 nm or about 20 nm thickness. The seed layer 152 can have a (002) c-axis crystal orientation. The seed layer 152 is not superconducting at the operating temperature of the device 150.

The superconductive wires 52 are formed on, e.g., in direct contact with, the seed layer 152. The wires are formed of niobium nitride (NbN), titanium nitride (TiN), or niobium titanium nitride (Nb_{X}Ti_{1-X}N). The wires 52 can have a width of about 25 to 250 nm, e.g., about 60 nm, and a thickness of 4 to 50 nm, e.g., about 5 nm or about 10 nm or about 20 nm.

A capping layer 154 can cover the superconductive wires 52. The capping layer 154 serves as a protective layer, e.g., to prevent oxidation of the metal nitride of the superconductive wires 52 or other types of contamination or damage. The capping layer 154 can be dielectric or conductive but is not superconductive at the operating temperature of the device 150. The capping layer 154 can be amorphous silicon (a-Si). In some implementations, the capping layer 154 is a nitride of a different material from the metal of the metal nitride used for the superconductive layer 52. Examples of materials for the capping layer 104 include AlN, Al₂O₃, SiO₂, and SiN. The capping layer 104 can be deposited by a standard chemical vapor deposition or physical vapor deposition process.

Trenches that separate the wires 52 can extend through the capping layer 154, the superconductive layer that provides the wires 52, and the seed layer 152. The trenches need not extend into the waveguide. (3) = In an example not encompassed by the wording of the claims, but useful for understanding the invention, FIG. 10 illustrates a cross-sectional side view of awaveguide-configuration of a superconducting nanowire single photon detector (SNSPD) device 150'. The SNSPD device 150' can be similar to the devices described above with respect to FIG. 9, except as described below.

In the example shown in FIG. 10, the waveguide 66' is formed of aluminum nitride (AlN). Thus a separate seed layer is unnecessary, and the waveguide 66' itself acts as the seed layer for the NbN.

The dielectric layer 64 can be silicon oxide (SiO₂), although other materials having a refractive index less than that of the aluminum nitride of the waveguide 66' are possible, e.g., silicon nitride (Si₃N₄). As noted above, the particular thickness and width of the waveguide can be selected based on the wavelength of light to be captured and detected. The waveguide 66' can have a thickness of 400 to 500 nm, e.g., 450 nm, for 1550 nm light. The width of the waveguide 66', i.e., perpendicular to the direction of propagation of the light entering the waveguide 66', can be 1.1 to 1.3 um, e.g., 1.2 um for 1550 nm light.

The superconductive wires 52 are formed on, e.g., in direct contact with, the waveguide 66'.

While particular implementations have been described, other and further implementations may be devised without departing from the basic scope of this disclosure. It is contemplated that elements and features of one embodiment may be beneficially incorporated in other embodiments without further recitation. It is to be noted, however, that the drawings illustrate only exemplary embodiments. The scope of the invention is determined by the claims that follow.

## Claims

1. A superconducting nanowire single photon detector (SNSPD) device (100), comprising:
a substrate (22);
a distributed Bragg reflector (24) on the substrate, the distributed Bragg reflector comprising a plurality of bi-layers (26), each bi-layer including lower layer (26a) of a first material and an upper layer (26b) of a second material having a higher index of refraction than the first material;
a seed layer (102) of a metal nitride on the distributed Bragg reflector, wherein the seed layer covers the upper layer (26b) of a topmost bilayer (26) of the distributed Bragg reflector, wherein the first material is the metal nitride of the seed layer; and
a superconductive wire (12) on the seed layer, the superconductive wire being a metal nitride different from the metal nitride of the seed material.

2. The device of claim 1, wherein the first material and the metal nitride of the seed layer are aluminum nitride.

3. The device of claim 1, wherein the second material is amorphous silicon.

4. The device of claim 1 or 2, wherein the first material and second material are selected from the group consisting of SiO₂, AlN, Ta₂O₅, a-Si, TiO₂ and Nb₂O₅.

5. The device of claim 1 or 2, wherein the metal nitride is niobium nitride, titanium nitride, or niobium titanium nitride, particularly wherein the metal nitride layer comprises δ-phase NbN.

6. The device of claim 1, further comprising a capping layer (104) on the superconductive wire.

7. The device of claim 6, wherein the capping layer is amorphous silicon or wherein the superconductive wire includes a plurality of wire portions, and trenches that separate the plurality of wires portions extend through the capping layer.

8. The device of claim 1, wherein the superconductive wire includes a plurality of wire portions, and trenches that separate the plurality of wires portions do not extend into the Bragg reflector.

9. The device of claim 8, wherein the trenches do not extend into the seed layer or wherein the trenches extend into the seed layer.

10. The device of claim 1, wherein the seed layer is in direct contact with the distributed Bragg reflector and the superconductive wire is in direct contact with the seed layer.

11. The device of claim 2, wherein:
the superconductive wires are niobium nitride, titanium nitride, or niobium titanium nitride.

12. The device of claim 11, wherein the seed layer has a thickness of 4 to 50 nm or wherein the superconductive wire has a thickness of 4 to 50 nm.

13. The device of any one of claims 1 and 11, wherein the second material is selected from the group consisting of a-Si, TiO₂ and Nb₂O₅.

## Patentansprüche

1. Supraleitende Nanodraht-Einzelphotonendetektor-(SNSPD)-Vorrichtung (100), umfassend:
ein Substrat (22);
einen verteilten Bragg-Reflektor (24) auf dem Substrat, wobei der verteilte Bragg-Reflektor eine Vielzahl von Doppelschichten (26) aufweist, wobei jede Doppelschicht eine untere Schicht (26a) aus einem ersten Material und eine obere Schicht (26b) aus einem zweiten Material aufweist, das einen höheren Brechungsindex als das erste Material aufweist;
eine Keimschicht (102) aus einem Metallnitrid auf dem verteilten Bragg-Reflektor, wobei die Keimschicht die obere Schicht (26b) einer obersten Doppelschicht (26) des verteilten Bragg-Reflektors bedeckt, wobei das erste Material das Metallnitrid der Keimschicht ist; und
einen supraleitenden Draht (12) auf der Keimschicht, wobei der supraleitende Draht ein Metallnitrid ist, das sich von dem Metallnitrid des Keimmaterials unterscheidet.

2. Vorrichtung nach Anspruch 1, wobei das erste Material und das Metallnitrid der Keimschicht Aluminiumnitrid sind.

3. Vorrichtung nach Anspruch 1, wobei das zweite Material amorphes Silizium ist.

4. Vorrichtung nach Anspruch 1 oder 2, wobei das erste Material und das zweite Material aus der Gruppe ausgewählt sind, die aus SiO₂, AlN, Ta₂O₅, a-Si, TiO₂ und Nb₂O₅ besteht.

5. Vorrichtung nach Anspruch 1 oder 2, wobei das Metallnitrid Niobnitrid, Titannitrid oder Niobtitannitrid ist, insbesondere wobei die Metallnitridschicht δ-Phasen-NbN aufweist.

6. Vorrichtung nach Anspruch 1, ferner umfassend eine Deckschicht (104) auf dem supraleitenden Draht.

7. Vorrichtung nach Anspruch 6, wobei die Deckschicht amorphes Silizium ist oder wobei der supraleitende Draht eine Vielzahl von Drahtabschnitten aufweist und Gräben, die die Vielzahl von Drahtabschnitten trennen, sich durch die Deckschicht erstrecken.

8. Vorrichtung nach Anspruch 1, wobei der supraleitende Draht eine Vielzahl von Drahtabschnitten aufweist und Gräben, die die Vielzahl von Drahtabschnitten trennen, sich nicht in den Bragg-Reflektor erstrecken.

9. Vorrichtung nach Anspruch 8, wobei sich die Gräben nicht in die Keimschicht erstrecken oder wobei sich die Gräben in die Keimschicht erstrecken.

10. Vorrichtung nach Anspruch 1, wobei sich die Keimschicht in direktem Kontakt mit dem verteilten Bragg-Reflektor befindet und sich der supraleitende Draht in direktem Kontakt mit der Keimschicht befindet.

11. Vorrichtung nach Anspruch 2, wobei:
die supraleitenden Drähte Niobnitrid, Titannitrid oder Niobtitannitrid sind.

12. Vorrichtung nach Anspruch 11, wobei die Keimschicht eine Dicke von 4 bis 50 nm aufweist oder wobei der supraleitende Draht eine Dicke von 4 bis 50 nm aufweist.

13. Vorrichtung nach einem der Ansprüche 1 und 11, wobei das zweite Material aus der Gruppe ausgewählt ist, die aus a-Si, TiO₂ und Nb₂O₅ besteht.

## Revendications

1. Dispositif (100) détecteur de photon unique à nanofil supraconducteur (SNSPD), comprenant :
un substrat (22) ;
un réflecteur de Bragg distribué (24) sur le substrat, le réflecteur de Bragg distribué comprenant une pluralité de bicouches (26), chaque bicouche comportant une couche inférieure (26a) constituée d'un premier matériau et une couche supérieure (26b) constituée d'un second matériau ayant un indice de réfraction plus élevé que le premier matériau ;
une couche de germination (102) constituée d'un nitrure métallique sur le réflecteur de Bragg distribué, dans lequel la couche de germination recouvre la couche supérieure (26b) d'une bicouche la plus haute (26) du réflecteur de Bragg distribué, dans lequel le premier matériau est le nitrure métallique de la couche de germination ; et
un fil supraconducteur (12) sur la couche de germination, le fil supraconducteur étant un nitrure métallique différent du nitrure métallique du matériau de germination.

2. Dispositif selon la revendication 1, dans lequel le premier matériau et le nitrure métallique de la couche de germination sont du nitrure d'aluminium.

3. Dispositif selon la revendication 1, dans lequel le second matériau est du silicium amorphe.

4. Dispositif selon la revendication 1 ou 2, dans lequel le premier matériau et le second matériau sont choisis dans le groupe constitué de SiO₂, AIN, Ta₂O₅, a-Si, TiO₂ et Nb₂O₅.

5. Dispositif selon la revendication 1 ou 2, dans lequel le nitrure métallique est du nitrure de niobium, du nitrure de titane, ou du nitrure de niobium et titane, en particulier dans lequel la couche de nitrure métallique comprend NbN en phase δ.

6. Dispositif selon la revendication 1, comprenant en outre une couche de coiffage (104) sur le fil supraconducteur.

7. Dispositif selon la revendication 6, dans lequel la couche de coiffage est du silicium amorphe ou dans lequel le fil supraconducteur comporte une pluralité de portions de fil, et des tranchées qui séparent la pluralité de portions de fil s'étendent à travers la couche de coiffage.

8. Dispositif selon la revendication 1, dans lequel le fil supraconducteur comporte une pluralité de portions de fil, et des tranchées qui séparent la pluralité de portions de fil ne s'étendent pas dans le réflecteur de Bragg.

9. Dispositif selon la revendication 8, dans lequel les tranchées ne s'étendent pas dans la couche de germination ou dans lequel les tranchées s'étendent dans la couche de germination.

10. Dispositif selon la revendication 1, dans lequel la couche de germination est en contact direct avec le réflecteur de Bragg distribué et le fil supraconducteur est en contact direct avec la couche de germination.

11. Dispositif selon la revendication 2, dans lequel :
les fils supraconducteurs sont du nitrure de niobium, du nitrure de titane, ou du nitrure de niobium et titane.

12. Dispositif selon la revendication 11, dans lequel la couche de germination a une épaisseur de 4 à 50 nm ou dans lequel le fil supraconducteur a une épaisseur de 4 à 50 nm.

13. Dispositif selon l'une quelconque des revendications 1 et 11, dans lequel le second matériau est choisi dans le groupe constitué de a-Si, TiO₂ et Nb₂O₅.
